# EUROPÄISCHE PATENTANMELDUNG

(11) **EP 4 386 310 A1**
(43) Veröffentlichungstag der Anmeldung: **19.06.2024**
(21) Anmeldenummer: 23217287.4
(22) Anmeldetag: 15.12.2023
(51) Int. Cl.: G01B 7/00, G01D 5/20

(54) **VERFAHREN ZUR LAGEBESTIMMUNG DER ADERN EINES TWISTED-PAIR-KABELS**

(30) Priorität: 16.12.2022 DE 102022133744
(71) Anmelder: Wieland Electric GmbH, 96052 Bamberg (DE)
(72) Erfinder: Bilz, Falko, 14612 Falkensee (DE)
(74) Vertreter: 2K Patentanwälte Blasberg Kewitz & Reichel

(57) **Zusammenfassung**

Ein Verfahren zur Lagebestimmung der Adern eines Twisted-Pair-Kabels (1) soll ein Verbinden von Twisted-Pair-Kabeln mit der Piercing-Technik erlauben. Hierzu wird an einer Mehrzahl von Punkten in einem bezüglich einer Achse des Twisted-Pair-Kabels (1) axial und/oder azimutal ausgedehnten Abtastbereich die induktive Kopplung zwischen einem im jeweiligen Punkt angeordneten ersten Stromkreis und dem Twisted-Pair-Kabel (1) als zweitem Stromkreis ermittelt, und anhand der ermittelten Werte für die induktive Kopplung an den Punkten eine Lage der Adern des Twisted-Pair-Kabels (1) bestimmt.

## Beschreibung

Die Erfindung betrifft ein Verfahren zur Lagebestimmung der Adern eines Twisted-Pair-Kabels. Sie betrifft weiter eine Vorrichtung zur Lagebestimmung der Adern eines Twisted-Pair-Kabels sowie ein System, umfassend eine derartige Vorrichtung sowie eine Vorrichtung zum Piercen eines Twisted-Pair-Kabels.

Als Twisted-Pair-Kabel, Kabel mit verdrillten Adernpaaren oder Kabel mit verdrillten Doppeladern, bezeichnet man in der Telekommunikations-, Nachrichtenübertragungs- und Computertechnik Kabeltypen, in denen die Adern paarweise miteinander verdrillt sind. Adernpaare können mit unterschiedlicher Schlaglänge und unterschiedlichem Drehsinn in einem Kabel verseilt werden, um das Übersprechen zwischen den Adernpaaren zu minimieren. Verdrillte Adernpaare bieten gegenüber parallel geführten Adern einen besseren Schutz gegenüber elektrischen und magnetischen Störfeldern. Durch das Verdrillen der Adernpaare heben sich Beeinflussungen durch äußere Felder größtenteils gegenseitig auf. Kabel mit verdrillten Adernpaaren werden für alle Arten der Signalübertragung eingesetzt, u. a. in der Netztechnik z. B. als Ethernet-Kabel oder für die strukturierte Verkabelung oder in der Feldbustechnik.

Nachteilig an Twisted-Pair-Kabeln ist jedoch, dass der Anschluss solcher Kabel in der Regel ein Abisolieren und Trennen beider Adern erfordert. Dies erfordert einen erhöhten manuellen Aufwand bei der Montage. Techniken, die kein Abisolieren der Adern erfordern, wie z.B. die Piercing- oder Durchdringungstechnik, bei der Durchdringungsdorne vorgesehen sind, die sich bei der Montage durch die Leiter des Kabels bohren, würden eine genaue Kenntnis der Verdrillposition erfordern.

Es ist daher Aufgabe der Erfindung, ein Verfahren der eingangs genannten Art anzugeben, welches ein Verbinden von Twisted-Pair-Kabeln mit der Piercing-Technik erlaubt.

Diese Aufgabe wird erfindungsgemäß gelöst, indem an einer Mehrzahl von Punkten in einem bezüglich einer Achse des Twisted-Pair-Kabels axial und/oder azimutal ausgedehnten Abtastbereich die induktive Kopplung zwischen einem im jeweiligen Punkt angeordneten ersten Stromkreis und dem Twisted-Pair-Kabel als zweitem Stromkreis ermittelt wird, und anhand der ermittelten Werte für die induktive Kopplung an den Punkten eine Lage der Adern des Twisted-Pair-Kabels bestimmt wird.

Die Erfindung geht dabei von der Überlegung aus, dass eine Positionsermittlung der Lage der Adern insbesondere durch die magnetischen Eigenschaften der Adernpaare des Twisted-Pair-Kabels möglich ist. In diesem Sinne bezeichnet der Begriff induktive Kopplung im Sinne dieser Anmeldung jegliche Kopplung eines Magnetfeldes in einen nicht verbundenen Stromkreis, bei dem Eigenschaften dieses Stromkreises durch das Magnetfeld geändert werden, insbesondere die Induktion eines Stroms, die Änderung einer Spannung (wie beim Hall-Effekt) oder die Änderung eines Widerstands (wie bei anderen magnetoresistiven Effekten). Durch die Verdrillung wird sich nämlich die Stärke der induktiven Kopplung orts- und richtungsabhängig entlang der verdrillten Leitung ändern. Durch die Periodizität bilden sich in entsprechender Periode auch Minima und Maxima aus. Abhängig von der verwendeten Art der Stromkreise und ihrer konkreten Anordnung zueinander werden sich Maxima bzw. Minima dann ausbilden, wenn der Sensor parallel oder senkrecht zu den zwei nebeneinanderliegenden Leitern liegt. Dadurch ist eine solche Position "Twisted-Pair-Kabel nebeneinander" durch Finden eines entsprechenden Maximums oder Minimums der induktiven Kopplung auf den Punkten auffindbar. Die Abtastung kann dabei entweder axial, d.h. entlang der Leitung, oder azimuthal, d.h. in Umfangsrichtung erfolgen. Der Abstand zur Achse der Leitung sollte dabei jedoch konstant bleiben, der Bereich ist also auf einer Zylindermantelfläche um das Twisted-Pair-Kabel definiert.

Vorteilhafterweise wird mit dem Verfahren daher eine radiale Position gegenüber dem Twisted-Pair-Kabel bestimmt, bezüglich der die Adern des Twisted-Pair-Kabels nebeneinander angeordnet sind. Hiermit ist eine Position gemeint, von der aus gesehen in radialer Richtung zur Achse des Twisted-Pair-Kabels hin die gedachte Verbindungslinie zwischen den Adern senkrecht zur radialen Richtung steht, die Adern also nebeneinander liegen. Eine solche Position eignet sich dann nämlich zum Verbinden des Twisted-Pair-Kabels mittels Piercing-Technik, indem aus radialer Richtung zwei im Abstand der Adern angeordnete Durchdringungsdorne in das Kabel eingestochen werden.

In einer ersten vorteilhaften Ausgestaltung des Verfahrens erfolgt die Ermittlung der induktiven Kopplung an den Punkten sequentiell. Dies kann beispielsweise erfolgen, indem der erste Stromkreis nacheinander an jedem der Punkte positioniert wird. In einer derartigen Ausgestaltung wird der zweite Stromkreis in Relation zu dem Twisted-Pair-Kabel in azimuthaler oder axialer Richtung bewegt, um ein Minimum oder Maximum der induktiven Kopplung zu finden. Die Punkte können hierbei demnach nicht nur diskret, sondern als Kontinuum gebildet sein, indem eine vorgegebene Länge des Kabels (die vorteilhafterweise mindestens eine Verdrillperiode des Twisted-Pair-Kabels lang ist) abgefahren wird.

Alternativ können mehrere erste Stromkreise an diskreten Punkten vorgesehen sein, in denen die Ermittlung der induktiven Kopplung nacheinander erfolgt. In diesem Fall sind die für eine Messung oder Ermittlung der induktiven Kopplung vorgesehenen Punkte dann diskret. In beiden beschriebenen Fällen der sequentiellen Ermittlung können mechanische Hilfsmittel wie z.B. ein Schlitten zur Anwendung kommen, der einen gleichmäßigen radialen Abstand des oder der jeweiligen Stromkreise(s) zum Twisted-Pair-Kabel gewährleistet.

In einer zweiten vorteilhaften Ausgestaltung erfolgt die Ermittlung der induktiven Kopplung an den Punkten parallel. Dies erfolgt dann insbesondere, indem eine Vielzahl von ersten Stromkreisen an jedem der Punkte angeordnet ist. Die Messung der induktiven Kopplung erfolgt dann gleichzeitig in allen ersten Stromkreisen.

Hierbei erfolgt vorteilhafterweise die Ermittlung der induktiven Kopplung, indem jeder erste Stromkreis als Primärkreis und der zweite Stromkreis als Sekundärkreis ausgebildet ist, oder indem der zweite Stromkreis als Primärkreis ausgebildet ist und jeder erste Stromkreis als Sekundärkreis ausgebildet ist, wobei im Primärkreis ein Stromfluss verursacht wird, und eine dadurch im jeweiligen Sekundärkreis induzierte Strom- und/oder Spannungsänderung gemessen wird. Mit anderen Worten: Es kann sowohl ein Stromfluss im Twisted-Pair-Kabel erzeugt werden, dessen magnetisches Feld dann in dem oder den ersten von außen herangeführten Stromkreis(en) gemessen wird, oder es wird ein Stromfluss im ersten Stromkreis erzeugt, dessen magnetische Auswirkung auf das Twisted-Pair-Kabel gemessen wird (z.B. indem dann der dort induzierte Strom gemessen wird).

In letzterem Fall wäre ohne zusätzliche Maßnahmen eine sequentielle Ermittlung erforderlich, da nur eine Messstelle (das Twisted-Pair-Kabel) vorliegt und sonst die Auswirkungen jedes einzelnen ersten Stromkreises nicht unterschieden werden könnten. Dies wird jedoch ermöglicht, indem für den Fall, dass jeder erste Stromkreis als Primärkreis und der zweite Stromkreis als Sekundärkreis ausgebildet ist, und dass eine Mehrzahl erster Stromkreise vorgesehen ist, vorteilhafterweise der in jedem Primärkreis verursachte Stromfluss ein Wechselstromssignal unterschiedlicher Frequenz ist und ein Vergleich der Amplituden der Frequenzanteile im Sekundärkreis erfolgt. Durch die Verwendung unterschiedlicher Frequenzen in jedem Primärkreis wird nämlich eine Identifizierung jedes Primärkreises im überlagerten Signal im Sekundärkreis möglich. Hierzu müssen lediglich die Amplituden der jeweiligen Frequenzanteile im überlagerten Signal im Sekundärkreis ermittelt werden, wodurch ein Vergleich der Stärke der magnetischen Kopplung zwischen jedem Primärkreis und dem Sekundärkreis ermöglicht wird.

Die Verursachung des Stromflusses im Primärkreis (der - wie oben erläutert - sowohl der außerhalb angeordnete erste Stromkreis oder aber das Twisted-Pair-Kabel selbst sein kann) wird vorteilhafterweise durch Anschluss an eine Stromquelle oder durch Induktion erzeugt. Wird an den jeweiligen ersten Stromkreis oder das Twisted-Pair-Kabel als zweitem Stromkreis direkt eine Stromquelle angeschlossen, sind beliebige Signale möglich. Beispielsweise kann zwischen den Adern ein beliebiges Wechselstromsignal eingespeist werden. Alternativ kann auch ein Gleichstromsignal verwendet werden. Alternativ kann das Verursachen des Stromflusses auch durch Induktion erfolgen. Hierfür ist dann aber ein Wechselstrom nötig. Z.B. kann das Twisted-Pair-Kabel jeweils beidseitig kurzgeschlossen werden (d. h. die Enden der Adern je Seite miteinander) und es wird eine Spule in die Nähe des Kabels gebracht, die dann induktiv den entsprechenden Stromfluss im Kabel erzeugt. Hierbei kann die Induktion durch Stromfluss in der in die Nähe des Kabels gebrachten Spule oder durch Bewegung dieser Spule erfolgen. Entsprechend kann ein Stromfluss auch durch Verbinden des oder der ersten Stromkreise(s) mit einer Stromquelle erfolgen, wenn die Ermittlung der induktiven Kopplung durch Messung des induzierten Stroms im Twisted-Pair-Kabel erfolgt.

Ist der oder die erste(n) Stromkreis(e) als Sekundärkreis ausgebildet, so ist der jeweilige Sekundärkreis vorteilhafterweise als Magnetfeldsensor, insbesondere als magnetoresistiver Sensor, als Hall-Sensor oder als Fluxgate-Magnetometer ausgebildet. Mit allen genannten Sensoren ist es möglich, zuverlässig die Stärke der induktiven Kopplung zu ermitteln.

Alternativ ist jeder erste Stromkreis vorteilhafterweise als Spule ausgebildet. Diese kann dabei als Luftspule oder als Spule mit massivem Kern ausgebildet sein. Dabei kann der Kern der Spule auf vorteilhafterweise eine Form aufweisen, die eine präzisere Ermittlung der induktiven Kopplung erlaubt, indem z.B. die Enden des Kerns in Richtung des Twisted-Pair-Kabels gerichtet sind. Eine Ausgestaltung also Spule ist für beide Messrichtungen möglich, d.h. entweder wenn der erste Stromkreis als Primärkreis oder wenn er als Sekundärkreis ausgebildet ist.

Vorteilhafterweise sind hierbei der oder die erste(n) Stromkreis(e) so angeordnet, dass die jeweilige Spule tangential zur Achse des Twisted-Pair-Kabels ausgerichtet wird, d.h. die Achse der Spule ist nicht parallel zur Achse des Twisted-Pair-Kabels ausgerichtet, sondern tangential zu einem gedachten Kreis um die Achse des Twisted-Pair-Kabels. In einer derartigen Anordnung ergibt sich eine maximale induktive Kopplung, so dass die Maxima und Minima im Bereich der Ermittlung besonders einfach bestimmt werden können.

In vorteilhafter Ausgestaltung des Verfahrens ist der im Primärkreis verursachte Stromfluss als unsymmetrisches Wechselstromssignal ausgebildet. Da die Signalform im erzeugten Magnetfeld abgebildet wird, wird sie entsprechend auch gemessen. Ist das Wechselstromssignal unsymmetrisch, insbesondere wenn es zwischen den Adern des Twisted-Pair-Kabels als Primärkreis eingespeist wird, ist damit nicht nur die Lage der Adern zueinander (nebeneinander oder übereinander) ermittelbar, sondern es ist sogar die einzelne Ader identifizierbar.

Eine Vorrichtung zur Lagebestimmung der Adern eines Twisted-Pair-Kabels umfasst vorteilhafterweise eine Anzahl von ersten Stromkreisen, zumindest eine Stromquelle sowie eine Spule oder einen Magnetfeldsensor, und ist ausgebildet zum Ausführen eines der oben beschriebenen Verfahren.

Eine derartige Vorrichtung umfasst vorteilhafterweise eine Anzeigeeinrichtung, auf der eine Lage der Adern in dem Bereich angezeigt wird. Diese kann vorteilhafterweise als Display ausgebildet sein, welches sich parallel zum Twisted-Pair-Kabel erstreckt und auf dem die Lage des Twisted-Pair-Kabels an der jeweiligen Position des Displays symbolisch angezeigt wird.

Weiterhin umfasst eine beschriebene Vorrichtung vorzugsweise erste, der Stromquelle zugeordnete Kommunikationsmittel, sowie zweite, der Spule oder dem Magnetfeldsensor zugeordnete Kommunikationsmittel, die zur Datenübertragung zwischen den ersten und zweiten Kommunikationsmitteln durch Modulation von Datensignalen auf das Twisted-Pair-Kabel ausgebildet sind. Da eine beschriebene Vorrichtung zwei räumlich voneinander getrennte Komponenten aufweist, nämlich solche zur Steuerung der Stromquelle zur Verursachung eines Stroms im jeweiligen Primärkreis, und solche zur Steuerung der Messung der magnetischen Kopplung im Sekundärkreis, ermöglicht eine Datenübertragung via Modulation auf das Twisted-Pair-Kabel eine kompaktere Bauweise der Vorrichtung, da eine externe Verkabelung oder ein weiterer, optional auch drahtloser, Übertragungsweg zwischen beiden Komponenten entfallen könnte. So könnte beispielsweise eine zentrale Steuereinrichtung auf der Sekundärseite vorgesehen sein, die automatisiert einen Messvorgang startet und die Signale zum Start der Verursachung der Ströme in den jeweiligen Primärkreisen (z. B. "Primärkreis 2 an/aus mit Frequenz X") per Modulation über das Twisted-Pair-Kabel an die Komponente zur Steuerung der Stromquelle überträgt.

Ein System umfasst vorteilhafterweise eine oben beschriebene Vorrichtung eine Vorrichtung zum Piercen eines Twisted-Pair-Kabels, und einen Schlitten, wobei der Schlitten Arretierungsmittel auf dem Twisted-Pair-Kabel aufweist. Der Schlitten soll sich also in axialer und/oder azimuthaler Richtung entlang und/oder um das Twisted-Pair-Kabel bewegen lassen, wobei jedoch ein konstanter radialer Abstand zum Kabel eingehalten wird. Dabei sind Arretierungsmittel vorgesehen, die den Schlitten (nachdem eine geeignete Position durch Verschieben bestimmt wurde) in der bestimmten Position relativ zum Twisted-Pair-Kabel arretieren können. Hierzu verbinden sie vorteilhafterweise den Schlitten fest (aber lösbar) mit dem Twisted-Pair-Kabel. Der Schlitten weist weiter vorteilhafterweise Positionierungsmittel aufweist, wobei die Positionierungsmittel zur Anordnung entweder der beschriebenen Vorrichtung zur Lagebestimmung der Adern oder der Vorrichtung zum Piercen eines Twisted-Pair-Kabels in einer vordefinierten Position innerhalb des Positionierungsmittels ausgebildet sind. Mit anderen Worten: Die genannten Positionierungsmittel sollen dazu dienen, entweder die Vorrichtung zur Lagebestimmung oder die Vorrichtung zum Piercen alternativ auf dem Schlitten positionieren, wobei die Anordnung der beiden Vorrichtungen zueinander ortsstabil bleibt. Dies kann zum Beispiel durch eine identische Außenform der beiden Vorrichtungen mit einer entsprechenden negativen Form im Schlitten gewährleistet sein, oder durch geeignete Stifte auf dem Schlitten, die in Bohrlöcher in den Vorrichtungen eingreifen (oder umgekehrt). Ziel ist es, dass nach Ermittlung der geeigneten radialen Position und Verschiebung des Schlittens auch das Piercen der Kabel an der richtigen, ermittelten Position erfolgt. Hierfür weist die Anzeigeeinrichtung vorteilhafterweise eine Zielpositionsanzeige zur Ermittlung einer radialen Position gegenüber dem Twisted-Pair-Kabel auf, bezüglich der die Adern des Twisted-Pair-Kabels nebeneinander angeordnet sind.

Die mit der Erfindung erzielten Vorteile bestehen insbesondere darin, dass durch die Lageermittlung der Adern eines Twisted-Pair-Kabels mittels induktiver Kopplung ein Anschluss der Adern ohne manuelles Abisolieren und Trennen der Adern möglich wird. Die Lokalisierung der Position "Twisted-Pair-Kabel nebeneinander" (statt "übereinander") ermöglicht nämlich die Kontaktierung einer verdrillten Zweidrahtleitung durch Piercing-Technik. Damit wird der Einsatz derartiger verdrillter Leitungen, die u.a. für Single-Pair-Ethernet (SPE) gefordert sind, technisch einfacher. Besondere Vorteile des Magnetfeldprinzips sind u.a., dass elektrische Umgebungs-Feldkomponenten kaum störend wirken und das Verfahren auch für elektrisch geschirmte Twisted-Pair-Kabele verwendbar ist.

Ausführungsbeispiele der Erfindung werden im Folgenden anhand von Zeichnungen näher erläutert. Darin zeigen:
- Fig. 1: eine Vorrichtung zur Lagebestimmung der Adern eines Twisted-Pair-Kabels, wobei das Twisted-Pair-Kabel als Primärkreis dient und der Abtastbereich in axialer Richtung ausgedehnt ist,
- Fig. 2: die Vorrichtung nach Fig. 1, wobei der Abtastbereich in azimuthaler Richtung ausgedehnt ist,
- Fig. 3: eine entsprechende Vorrichtung mit einer Mehrzahl erster Stromkreise als Sekundärkreis, die in axialer Richtung erstreckt sind,
- Fig. 4: eine Vorrichtung ähnlich der Fig. 3, wobei die ersten Stromkreise nicht als Spulen, sondern anderweitige Magnetfelddetektoren ausgebildet sind,
- Fig. 5: eine Vorrichtung ähnlich der Fig. 1, wobei das Twisted-Pair-Kabel als Sekundärkreis dient,
- Fig. 6: eine Vorrichtung ähnlich der Fig. 5 mit mehreren ersten Stromkreisen als Primärkreis,
- Fig. 7: eine Vorrichtung ähnlich der Fig. 4, wobei im Twisted-Pair-Kabel als Primärkreis induktiv ein Strom verursacht wird,
- Fig. 8: einen Querschnitt durch ein Twisted-Pair-Kabel mit Darstellung einer Lage einer äußeren Spule mit maximaler induktiver Kopplung,
- Fig. 9: einen Querschnitt durch ein Twisted-Pair-Kabel mit Darstellung einer Lage einer alternativen äußeren Spule mit gebogenem Kern mit maximaler induktiver Kopplung,
- Fig. 10: eine Vorrichtung ähnlich der Fig. 4 oder Fig. 7 mit integriertem Display und Leuchtelementen zur Anzeige einer für die Anwendung der Piercing-Technik geeigneten Position,
- Fig. 11: einen Graphen eines asymmetrischen Wechselstromsignals, und
- Fig. 12: einen Schlitten mit einer Vorrichtung zum Piercen eines Twisted-Pair-Kabels und einer Vorrichtung zur Lagebestimmung der Adern eines Twisted-Pair-Kabels.

Gleiche Teile sind in allen Figuren mit denselben Bezugszeichen versehen.

Alle Zeichnungen erläutern Ausführungsbeispiele von oben beschriebenen Verfahren und Vorrichtungen zur Lagebestimmung der Adern eines Twisted-Pair-Kabels. Ziel ist es hierbei, eine Position und Richtung zu bestimmen, aus deren Sicht die Adern des Kabels nebeneinander liegen und somit mittels Piercing-Technik kontaktiert werden können. Gemein ist den Ausführungsbeispielen, dass einer oder mehrere außenliegende erste Stromkreise in einem axial und/oder azimuthal ausgedehnten Bereich um das Kabel gebracht werden, und in dem Bereich die induktive Kopplung dieses oder dieser Stromkreise(s) mit dem Twisted-Pair-Kabel als zweitem Stromkreis bestimmt wird. Abhängig von der Anordnung und der Art des ersten Stromkreises wird (aus Symmetrieüberlegungen) an einem Maximum oder Minimum der induktiven Kopplung ein solcher Punkt im Bereich auffindbar sein.

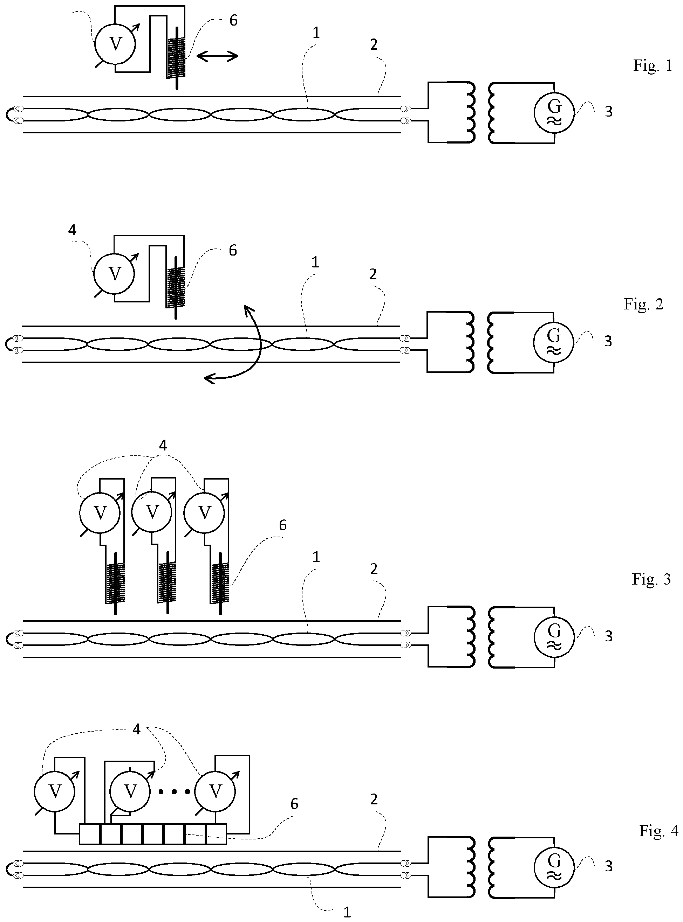

In einer ersten Gruppe vorteilhafter Ausprägungen wird durch das Twisted-Pair-Kabel (Leiterpaar) (1) ein Magnetfeld induziert (Fig. 1, Fig. 3 und Fig. 4). In diesem Fall ist das Twisted-Pair-Kabel (1) somit der Primärkreis. Das Twisted-Pair-Kabel (1) ist in den Ausführungsbeispielen von einem elektrischen Schirm (2) umgeben, das Verfahren ist in anderen Ausführungsbeispielen jedoch genauso anwendbar, wenn kein Schirm (2) vorhanden ist. Das Twisted-Pair-Kabel (1) wird an einem Punkt kurzgeschlossen. An einem zweiten Punkt wird ein Wechselstromgenerator (3) niedriger Impedanz angeschlossen. Zur Impedanztransformation nach dem Transformatorprinzip kann vorteilhaft ein Übertrager zwischen Twisted-Pair-Kabel (1) und Wechselstromgenerator geschaltet werden. In anderen, nicht gezeigten Ausführungsbeispielen kann auch in einer der der beiden Adern ein Gleichstrom erzeugt werden.

Der im Twisted-Pair-Kabel (1) fließende Strom generiert zwischen dem Kurzschluss- und dem Generator-Einspeisepunkt ein Magnetfeld, das entlang der verdrillten Leitung eine orts- und richtungsabhängige Stärke aufweist. Dieses lokale Magnetfeld wird mit einem Magnetfeldsensor (6) gemessen. Dieser ist in den Ausführungsbeispielen der Fig. 1-3 als Spule mit Eisenkern und angeschlossenem Spannungsmessgerät (4) ausgebildet. In Fig. 1 ist der Magnetfeldsensor (6) axial entlang der Leitung verschiebbar positionierbar, der Abtastbereich ist also axial erstreckt.

In einer alternativen vorteilhaften Ausgestaltung nach Fig. 2 wird optional durch Drehung der Leitung, die das verdrillte Twisted-Pair-Kabel (1) umfasst, das vom Magnetfeldsensor (6) erfasste Magnetfeld verändert. Der Abtastbereich ist hier also azimuthal erstreckt. In beiden Fällen findet jedoch eine sequentielle Abtastung des Bereichs statt.

In einer weiteren vorteilhaften Ausgestaltung sind mehrere Magnetfeldsensoren (6) nebeneinander angeordnet und messen parallel jeweils die lokale Magnetfeldstärke (Fig. 3 und Fig. 4). Als Magnetfeldsensoren können neben den schon erwähnten und in Fig. 1-3 dargestellten Spulen mit einem para- oder ferromagnetischen Kern, auch Luftspulen, Hallsensoren bzw. allgemein magnetoresistive Sensoren oder Fluxgate-Magnetometer verwendet werden. Dies ist symbolisch in den Fig. 4, 7 und 10 dargestellt.

Durch den induktiven und kapazitiven Belag des verdrillten Twisted-Pair-Kabels (1) ist die magnetische Kopplung frequenzabhängig und typisch zwischen 1 kHz und 1 MHz besonders hoch. Vorteilhafterweise werden daher bei Verwendung von Wechselstrom in den beschriebenen Verfahren Wechselströme mit Frequenzen zwischen 1 kHz und 1 MHz verwendet.

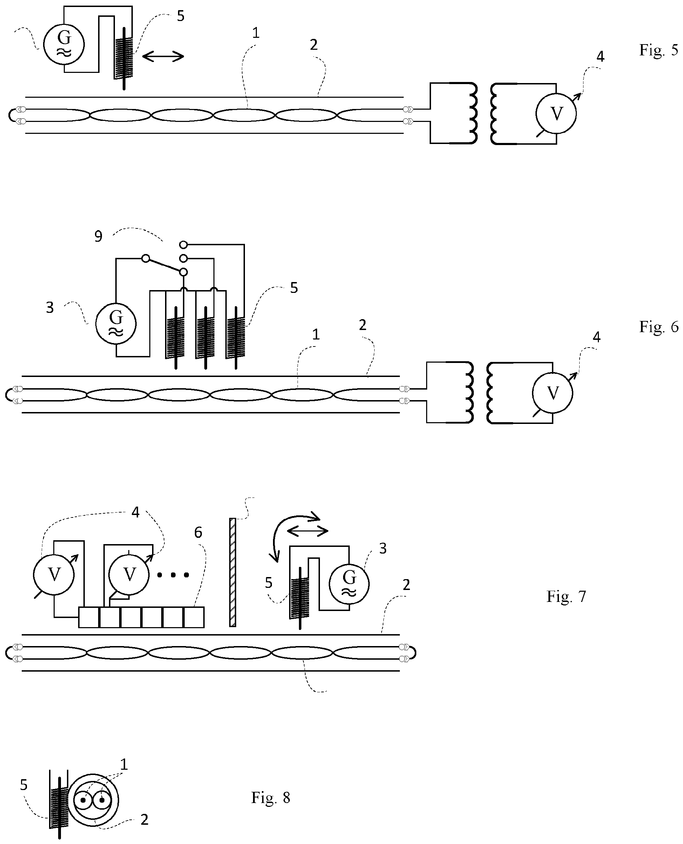

Antennen sind in ihrer Wirkung umkehrbar und so wird in einer zweiten Gruppe vorteilhafter Ausprägungen ein äußeres Magnetfeld erzeugt und das Twisted-Pair-Kabel (1) dient als Sekundärkreis als Detektor für die induktive Kopplung (Fig. 5 und Fig. 6). Die das Magnetfeld erzeugende äußere Spule (5) ist entlang der Leitung verschiebbar positionierbar (Fig. 5). Der Schleifenstrom im Twisted-Pair-Kabel (1) wird niederimpedant mittels eines an das Twisted-Pair-Kabel (1) angeschlossenen Spannungsmessgeräts (4) gemessen. Wird dazu ein hochohmiges Spannungsmessgerät (4) verwendet, erfolgt die Widerstandstransformation durch einen Übertrager. In einer weiteren vorteilhaften Ausgestaltung sind mehrere Spulen (5) nebeneinander angeordnet und über einen Umschalter (9) mit dem Wechselstromgenerator (3) verbunden (Fig. 6). In jedem Fall erfolgt jedoch eine sequentielle Messung an den verschiedenen Punkten im Abtastbereich.

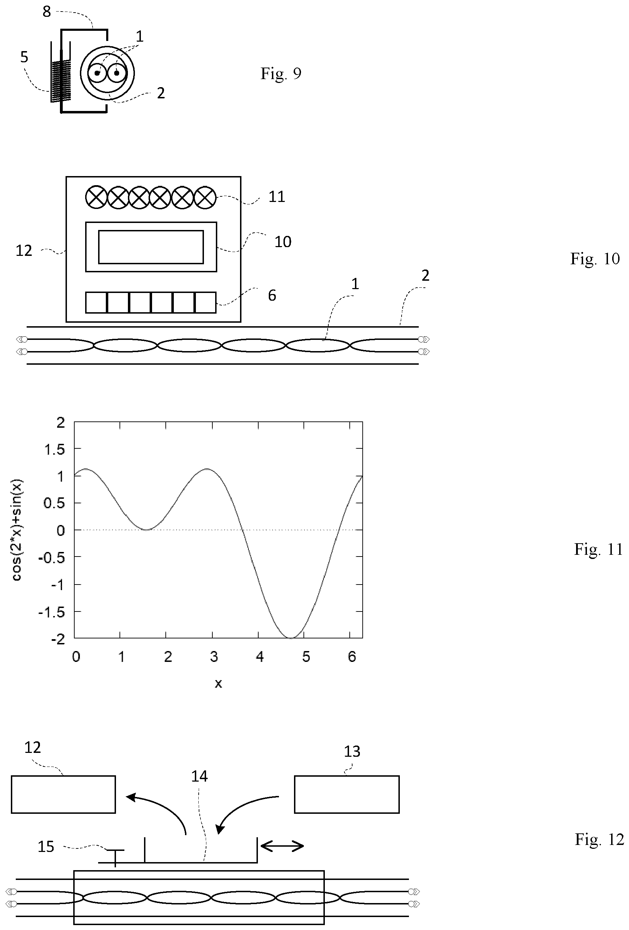

Wird eine Spule (5) als erster, von außen in den Abtastbereich geführter Stromkreis verwendet, wird deren Achse vorteilhaft radial zur Leitung mit dem Twisted-Pair-Kabel (1) orientiert (Fig. 1, Fig. 3, Fig. 5, Fig. 6 und Fig. 7). In einer weiteren vorteilhaften Ausgestaltung ist die Spulenachse tangential zur Leitung orientiert (Fig. 8). Der Spulenkern ist optional als Ringkern (8) mit Luftspalt ausgeführt, wobei sich in letzterem das verdrillte Twisted-Pair-Kabel (1) befindet (Fig. 9).

In einer weiteren vorteilhaften Ausgestaltung erfolgt die Einkopplung des Stromes in das Twisted-Pair-Kabel (1) als Primärkreis ebenfalls magnetisch bzw. induktiv (Fig. 7). Das Twisted-Pair-Kabel (1) ist dazu zweiseitig kurzgeschlossen. Die Ein- und Auskopplung des Magnetfeldes erfolgt zwischen diesen Punkten. Die Ein- und Auskopplungselemente sind dabei verschiebbar (Fig. 1) oder drehbar (Fig. 2) oder mehrfach (Fig. 3 und Fig. 4) ausgeführt. Hierdurch kann die Einkopplung des Signals in das Twisted-Pair-Kabel (1) optimiert werden. Vorteilhaft ist eine magnetische Abschirmung der Magnetfeldsensoren (6) in axialer Richtung von der, das Magnetfeld erzeugenden, Spule (5) durch beispielsweise eine Blende (7) aus Mu Metall.

Zur Unterscheidung der Einzeladern des verdrillten Twisted-Pair-Kabels (1) wird in Ausführungsbeispielen optional ein unsymmetrisches Wechselstromssignal verwendet (Fig. 11). Die Ausrichtung des damit erzeugten Magnetfeldes und damit die Polarität des Schleifenstroms und damit die Zuordnung der Einzeladern ist daraus eindeutig ermittelbar. Das unsymmetrische Wechselstromssignal hat vorteilhaft keinen Gleichspannungsanteil und wird in Fig. 11 beispielhaft durch die Signalform sin(x) + cos(2x) beschrieben.

Die gemessene ortsabhängige magnetische Koppelstärke zwischen dem Twisted-Pair-Kabel (1) und den äußeren Magnetfeldsonden bzw. Spulen (6) wird weitergehend optional durch ein Display (10) und/oder Leuchtelemente (11), beispielsweise LEDs usw., die in einem Gehäuse (12) montiert sind, visualisiert (Fig. 10). Aus der ortsabhängigen Koppelstärke kann auf die Orientierung des Twisted-Pair-Kabels (1) innerhalb der Leitung geschlossen werden. Der Leitungsmantel kann nun mit entsprechenden Markierungen beispielsweise durch Bedruckung versehen werden, wobei die Bedruckung geeignete Piercing-Punkte anzeigt.

Die ermittelte Orientierung des Twisted-Pair-Kabels (1) kann auch direkt zur Bestimmung der günstigen Positionen für eine Kontaktierung durch Piercing-Technik genutzt werden (Fig. 12). Dazu umfasst das gesamte System einen verschiebbaren Schlitten (14), der auf das Twisted-Pair-Kabel aufgelegt wird und einen gleichbleibenden radialen Abstand gewährleistet. Der Schlitten (14) umfasst Positionierungsmittel in Form einer Schale, in die einerseits die zuvor beschriebene Vorrichtung (12) eingelegt und damit eine günstige Kontaktierungsposition bestimmt wird. Nachdem die Position wird durch Verschieben des Schlittens (14) gefunden wurde, wird dieser auf dem Twisted-Pair-Kabel (1) mit Arretierungsmitteln (15) arretiert. Nun wird die Vorrichtung (12) abgenommen und durch eine Vorrichtung zur Kontaktierung (13) ersetzt, die genau die zuvor ermittelte und arretierte Kontaktierungsposition nutzt.

Das verdrillte Twisted-Pair-Kabel (1) ist vorteilhaft optional Teil einer Flachleitung. Bei diesen Leitungen ist die Verdrillposition nur von der Position entlang der Leitung abhängig, sofern die Einzeladern nahezu verdrehsicher mit der Flachleitung mechanisch verbunden sind.

Die magnetische Kopplung zwischen Twisted-Pair-Kabel (1) und äußerer Sonde wird weitergehend optional zur kontaktlosen Datenübertragung genutzt. Der induzierte Wechselstrom kann dabei alle bekannten Modulationsformen aufweisen, wie beispielsweise Amplituden-, Frequenz-, Phasenmodulation usw. und aus einem oder mehreren Trägerfrequenzen bestehen. Dies ermöglicht eine kompakte Bauform der Vorrichtung, da die dem Primärkreis zugeordneten Komponenten des Systems, die zur Verursachung des Stromes im Primärkreis dienen, mittels der Modulation mit den dem Sekundärkreis zugeordneten Komponenten des Systems kommunizieren können.

### Bezugszeichenliste

- 1: Twisted-Pair-Kabel
- 2: Schirm
- 3: Wechselstromgenerator
- 4: Spannungsmessgerät
- 5: Spule
- 6: Magnetfeldsensor
- 7: Blende
- 8: Ringkern
- 9: Umschalter
- 10: Display
- 11: Leuchtelement
- 12: Gehäuse
- 13: Vorrichtung zur Kontaktierung
- 14: Schlitten
- 15: Arretierungsmittel

## Patentansprüche

1. Verfahren zur Lagebestimmung der Adern eines Twisted-Pair-Kabels (1), wobei an einer Mehrzahl von Punkten in einem bezüglich einer Achse des Twisted-Pair-Kabels (1) axial und/oder azimutal ausgedehnten Abtastbereich die induktive Kopplung zwischen einem im jeweiligen Punkt angeordneten ersten Stromkreis und dem Twisted-Pair-Kabel (1) als zweitem Stromkreis ermittelt wird,
und anhand der ermittelten Werte für die induktive Kopplung an den Punkten eine Lage der Adern des Twisted-Pair-Kabels (1) bestimmt wird.

2. Verfahren nach dem vorhergehenden Anspruch, bei dem insbesondere eine radiale Position gegenüber dem Twisted-Pair-Kabel (1) bestimmt wird, bezüglich der die Adern des Twisted-Pair-Kabels (1) nebeneinander angeordnet sind.

3. Verfahren nach einem der vorhergehenden Ansprüche, bei dem die Ermittlung der induktiven Kopplung an den Punkten sequentiell erfolgt.

4. Verfahren nach einem der vorhergehenden Ansprüche, bei dem die Ermittlung der induktiven Kopplung an den Punkten parallel erfolgt.

5. Verfahren nach einem der vorhergehenden Ansprüche, bei dem die Ermittlung der induktiven Kopplung erfolgt, indem jeder erste Stromkreis als Primärkreis und der zweite Stromkreis als Sekundärkreis ausgebildet ist, oder indem der zweite Stromkreis als Primärkreis ausgebildet ist und jeder erste Stromkreis als Sekundärkreis ausgebildet ist, wobei im Primärkreis ein Stromfluss verursacht wird, und eine dadurch im jeweiligen Sekundärkreis induzierte Strom- und/oder Spannungsänderung gemessen wird.

6. Verfahren nach Anspruch 4 und der ersten Alternative nach Anspruch 5, d. h. dass jeder erste Stromkreis als Primärkreis und der zweite Stromkreis als Sekundärkreis ausgebildet ist, wobei eine Mehrzahl erster Stromkreise vorgesehen ist und wobei der in jedem Primärkreis verursachte Stromfluss ein Wechselstromsignal unterschiedlicher Frequenz ist und ein Vergleich der Amplituden der Frequenzanteile im Sekundärkreis erfolgt.

7. Verfahren nach einem der Ansprüche 5 oder 6, bei dem der Stromfluss im Primärkreis durch Anschluss an eine Stromquelle (3) oder durch Induktion erzeugt wird.

8. Verfahren nach einem der Ansprüche 5 bis 7, bei dem der jeweilige Sekundärkreis als Magnetfeldsensor (6), insbesondere als magnetoresistiver Sensor, als Hall-Sensor oder als Fluxgate-Magnetometer ausgebildet ist.

9. Verfahren nach einem der vorhergehenden Ansprüche, bei dem jeder erste Stromkreis als Spule (5) ausgebildet ist.

10. Verfahren nach Anspruch 9, bei dem die jeweilige Spule (5) tangential zur Achse des Twisted-Pair-Kabels (1) ausgerichtet wird.

11. Verfahren nach einem Ansprüche 5 bis 9, bei dem der im Primärkreis verursachte Stromfluss als unsymmetrisches Wechselstromsignal ausgebildet ist.

12. Vorrichtung zur Lagebestimmung der Adern eines Twisted-Pair-Kabels (1), umfassend eine Anzahl von ersten Stromkreisen, zumindest eine Stromquelle (3) sowie eine Spule (5) oder einen Magnetfeldsensor (6), ausgebildet zum Ausführen des Verfahrens nach einem der vorhergehenden Ansprüche.

13. Vorrichtung nach Anspruch 12, umfassend eine Anzeigeeinrichtung (10), auf der eine Lage der Adern in dem Bereich angezeigt wird.

14. Vorrichtung nach Anspruch 12 oder 13, mit ersten, der Stromquelle (3) zugeordneten Kommunikationsmitteln, sowie zweiten, der Spule (5) oder dem Magnetfeldsensor (6) zugeordneten Kommunikationsmitteln, die zur Datenübertragung zwischen den ersten und zweiten Kommunikationsmitteln durch Modulation von Datensignalen auf das Twisted-Pair-Kabel (1) ausgebildet sind.

15. System, umfassend eine Vorrichtung nach Anspruch 13, eine Vorrichtung zum Piercen eines Twisted-Pair-Kabels (1), und einen Schlitten (14), wobei der Schlitten (14) Arretierungsmittel (15) auf dem Twisted-Pair-Kabel (1) und Positionierungsmittel aufweist, wobei die Positionierungsmittel zur Anordnung entweder der Vorrichtung nach Anspruch 13 oder der Vorrichtung (13) zum Piercen eines Twisted-Pair-Kabels (1) in einer vordefinierten Position innerhalb des Positionierungsmittels ausgebildet sind, und die Anzeigeeinrichtung (10) eine Zielpositionsanzeige zur Ermittlung einer radialen Position gegenüber dem Twisted-Pair-Kabel (1) aufweist, bezüglich der die Adern des Twisted-Pair-Kabels (1) nebeneinander angeordnet sind.
